(19)

Europäisches
Patentamt
European
Patent Office
Office européen
des brevets

(11) **EP 2 308 796 A1**

(12) **EUROPEAN PATENT APPLICATION**

(43) Date of publication:
 **13.04.2011 Bulletin 2011/15**

(51) Int Cl.:
 **B81B 3/00** *(2006.01)*   **G01L 1/02** *(2006.01)*

(21) Application number: **09172715.6**

(22) Date of filing: **09.10.2009**

(84) Designated Contracting States:
 **AT BE BG CH CY CZ DE DK EE ES FI FR GB GR HR HU IE IS IT LI LT LU LV MC MK MT NL NO PL PT RO SE SI SK SM TR**
 Designated Extension States:
 **AL BA RS**

(71) Applicants:
 • **Université Libre de Bruxelles**
  **1050 Bruxelles (BE)**
 • **UNIVERSITE DE FRANCHE-COMTE**
  **25000 Besançon (FR)**
 • **Centre National de la Recherche Scientifique**
  **75795 Paris (FR)**

(72) Inventors:
 • **Lenders, Cyrille**
  **1200 Bruxelles (BE)**
 • **Lambert, Pierre**
  **1180 Bruxelles (BE)**
 • **Gauthier, Michaël**
  **39100 Monnieres (FR)**

(74) Representative: **Van Malderen, Joëlle**
 **pronovem - Office Van Malderen**
 **Avenue Josse Goffin 158**
 **1082 Bruxelles (BE)**

(54) **Meniscus-supported compliant table**

(57)   Apparatus for providing a compliance to an element (1), comprising means (2) for supporting the element so as to allow, in use, for at least two rotational degrees of freedom of the element. It is **characterised in that** the means for supporting the element comprises an anchoring edge (22) for a meniscus (21), provided at each of at least two separate locations isolated from the element and in contact with a first fluid in which the element is at least partially immersed when in use, and in that it comprises means for generating a meniscus at each of the separate locations from an interface between the first fluid and a second fluid, so that the meniscus (21) is anchored to the corresponding anchoring edge (22) when in use. The element (1) is arranged to be supported by each of the menisci (21) so that the compliance to the element (1) can be provided. The separate locations are arranged so that the compliance can be provided in respect of said rotational degrees of freedom. A method of measuring a force applied on the element (1) with the aid of the meniscus (21) is also provided.

FIG 1

EP 2 308 796 A1

**Description**

The present invention is related to elements, such as tables for assembly, which comprise a support that renders them compliant. The present invention is particularly related to the field of micro-applications and micro-assembly. Compliance refers to the presence of resilience and elastic deformation in order to compensate inaccuracies, such as positioning or manufacturing inaccuracies.

A micrometric system refers to a system comprising one or more components having a size falling in the range between 1 $\mu$m and 5 mm. The behavior of such systems is different from those of macrometric systems, since the predominant forces at this scale are not the same.

This may easily be demonstrated based on scaling law. Indeed, it can be demonstrated that some forces are proportional to the cube of the characteristic length of an object (such as the weight of the object), whereas other forces are proportional to the square of the characteristic length (such as the suction force of a vacuum gripper), or even proportional to the characteristic length (such as the surface tension force). If the size of an object is downscaled by 10, its weight will be divided by 1000, the suction force by 100 and the surface tension force by 10. The effect of surface tension forces can therefore overcome the effect of the weight.

One difficulty facing miniaturization is the positioning accuracy of manipulation systems. Such systems involve the handling of an object by a manipulator, e.g. taking it from or placing it onto a support or assembly table. The positioning accuracy may come close to the characteristic dimension of the object that is manipulated, which makes relative positioning more difficult than at macroscopic scale. Moreover, materials used are often brittle (silicon, ceramics) and have low ductility reserve. They do not tolerate much deformation before breaking.

In order to avoid that manufacturing or positioning errors induce the breaking of materials, it is necessary to introduce compliance. Compliance refers to the inverse of the stiffness. The more compliant a system is, the more flexible it is and the more it will be able to distort under low stress. A positioning error will henceforth distort the system instead of breaking the manipulated component.

Compliance can be introduced at the level of the manipulator and/or at the level of the support or assembly table. The present invention relates to compliance at the level of the support. A compliant table is therefore arranged to compensate a positioning error (of the manipulator) or manufacturing error (of the manipulated object), by moving, so as to absorb the error.

Compliant tables for micro-assembly are known from C. Clévy et al. "Flexible micro-assembly system equipped with an automated tool changer" in Journal of Micro - Nano Mechatronics 4 (2008), pp. 59-72. The table is suspended with the aid of three springs. The compliance level is function of the spring stiffness and is hence fixed, unless the springs are interchanged. Furthermore, the compliance is proportional to the length of the springs, which results in a very bulky set up.

There is therefore a need in the art to provide a table with improved compliance level, and which is furthermore adjustable without cumbersome interventions.

This is obtained by apparatuses as set out in the appended claims. Compliance is introduced, according to the present invention, by supporting the element, such as a table, by a plurality of curved interfaces between two fluid phases, which are referred to in the art as menisci, or bubbles.

It is known to position objects with the use of bubbles from WO 01/94823, disclosing at figure 18 a plate connected to two micro-fabricated tethers which are anchored at their other ends. An electrolytical bubble generator is provided beneath the plate in order to form bubbles for lifting and/or tilting the plate. The bubbles eventually aggregate to form one larger bubble.

Even though the above document fails to disclose the use of such bubble supported plate for introducing compliance, it could in principle be used therefore. The level of compliance would then be determined by the stiffness of the tethers, which function as springs, and by the stiffness of the air bubble. With such an arrangement, however, it appears difficult to control and adjust the level of compliance, without affecting the size of the bubble and, hence, the position of the plate.

It is therefore an aim of the present invention to provide a table (an element) which is so supported, that it provides for improved compliance compared to tables (elements) of the prior art. It is an aim of the present invention to provide such a table wherein the compliance level (stiffness of the support) is easily adjustable, within a certain range, and preferably independently of the position of the table. It is also an aim to provide such a table, that allows for improved stiffness control, and possibly position control as well.

According to a first aspect of the invention, there is thus provided an apparatus for providing a compliance to an element. The element can be any structure for which compliance is desired, such as a table (for micro-assembly or other micro-applications). The apparatus comprises the element and means for supporting the element so as to allow, in use, for at least two rotational degrees of freedom of the element. It is **characterised in that** the means for supporting the element comprises, firstly, an anchoring edge for a meniscus, provided at each of at least two separate locations isolated from the element. Such locations are hence provided separate from the element. The anchoring edge is in contact with a first fluid in which the element is at least partially immersed when in use. Secondly, the means for supporting the element comprises means for generating a meniscus at each of the separate locations. The meniscus is generated from an interface between the first fluid and a second fluid and it is anchored to the corresponding anchoring edge when in use.

The element is arranged to be supported by each of the menisci, so that the compliance to the element can be provided. Moreover, the separate locations are arranged so that the compliance can be provided in respect of said rotational degrees of freedom.

The use of menisci enables to obtain high compliance levels, as can be required for micro-applications in particular, due to the interplay of capillary forces and fluid pressure at the interface.

The meniscus preferably develops from the anchoring edge. It hence forms a cap. In case of a closed-edge anchoring edge (such as a circular one), the meniscus extends in the form of a cap, from the edge inwards. Therefore, a meniscus as referred to in the present invention preferably does not fully enclose the second fluid; such as would be the case in a closed bubble or globule. The meniscus is hence preferably not a closed volume.

Preferably, the apparatus is arranged to generate a meniscus in at least three separate locations for supporting the element. More preferably, the element is exclusively supported by the menisci. By consequence, the element can be compliant in respect of at least two rotational degrees of freedom and at least one translational degree of freedom. By providing three or more menisci, compliance with respect to all six degrees of freedom can be obtained.

Preferably, the apparatus comprises a cavity, preferably of tubular shape, arranged to contain the second fluid and abutting on the anchoring edge corresponding to a meniscus. In use, the second fluid in the cavity is in fluid connection with the meniscus.

Preferably, the (tubular) cavity is arranged to have a variable volume, which contains, in use, the second fluid in fluid connection with the meniscus. The variable volume enables adjustment of the stiffness of the meniscus. More preferably, the volume is kept constant and in isolation when in use, thereby imparting a predetermined stiffness to the meniscus during use.

Preferably, the apparatus comprises a plurality of reservoirs arranged to contain the second fluid and being individually connectable to a same cavity, so as to be in fluid communication with the cavity for adjusting the stiffness of the meniscus.

Preferably, the apparatus of any one preceding claim, comprises means for measuring pressure variations in the second fluid. The second fluid is in fluid connection with the meniscus.

Preferably, the first fluid is a liquid and the second fluid is a gas phase.

Preferably, the element comprises geometrical anchoring points for anchoring the meniscus to the element by capillarity. Such geometrical anchoring points can be (sharp) edges or ridges.

Preferably, the element comprises chemical anchoring points for anchoring the meniscus to the element by differences in wettability of the element's surface.

Another difficulty arising with miniaturization relates to the knowledge of the applied effort by the manipulation device. This information may be useful in particular to exert a controlled force when assembling components. Another implementation is the mechanical characterization of an object, for example of a biological cell. In such cases, the compliance introduced by apparatuses of the present invention can be used to deduce such a force.

It is therefore an aim of the present invention to provide a method of measuring the force exerted on an element, which is particularly suitable for micro-applications. It is an aim to provide such a method which is not cumbersome and does not interfere with the micro-application.

This is obtained by the method as set out in the appended claims. According to a second aspect of the invention, there is thus provided a method of measuring a force applied on an element. In a first step, at least one meniscus is generated, forming an interface between a first fluid in which the element is at least partially immersed and a second fluid, so that the element is in contact with the meniscus. In a second step, the second fluid is arranged in isolation, so that any pressure variation in the second fluid is induced by a change of the meniscus. In a third step, the pressure variation in the second fluid is measured.

Preferably, the first fluid is a liquid and the second fluid is a gas or air.

Preferably, the meniscus is formed at the end of a (tubular) cavity containing the second fluid and wherein the pressure variation is measured in the cavity, advantageously at a remote location from the meniscus.

## Brief Description of the Drawings

Figure 1 represents schematically a set-up of an apparatus according to the present invention, comprising a table supported by a compliant support making use of menisci.

Figure 2 represents a cross section of a meniscus at the end of a tubular passage.

Figure 3 represents schematically the means for generating a meniscus and for adjusting the stiffness of the meniscus for supporting and providing compliance to a table, according to the invention.

Figure 4 represents a table supported on a meniscus. The table is provided with a capillary stop (anchoring edge) to anchor the meniscus at predetermined locations.

**Detailed Description of the Invention**

Apparatuses according to the invention comprise a table for which compliance is desired. As the field of micro-assembly is particularly envisaged by the present invention, the compliant table can be a table for assembly of micrometric components. However, the invention is not limited to that field. Therefore, the table can refer to any element for which compliance is desired.

In the framework of micro-applications and micro-assembly in particular, preferred compliance levels relate to a stiffness in a point of support of the element (table) of not more than 20 N/m, preferably smaller than 10 N/m.

The term compliance refers to the presence of a certain degree of resilience in the support structure of the element (table). It refers to the support of the element having a degree of elasticity such that (elastic) motion in respect of one or more degrees of freedom of the element is possible.

In particular, the present invention is concerned with compliance in respect of at least two rotational degrees of freedom. Preferably, the rotational degrees of freedom relate to rotations on axes comprising or going through points in which the table (element) is supported. In addition, compliance in respect of at least one translational degree of freedom can be obtained, in particular compliance in respect of a translation perpendicular to the plane defined by the points of support of the table. Compliance in respect of the remaining (rotational and two translational) degrees of freedom can advantageously be obtained as well.

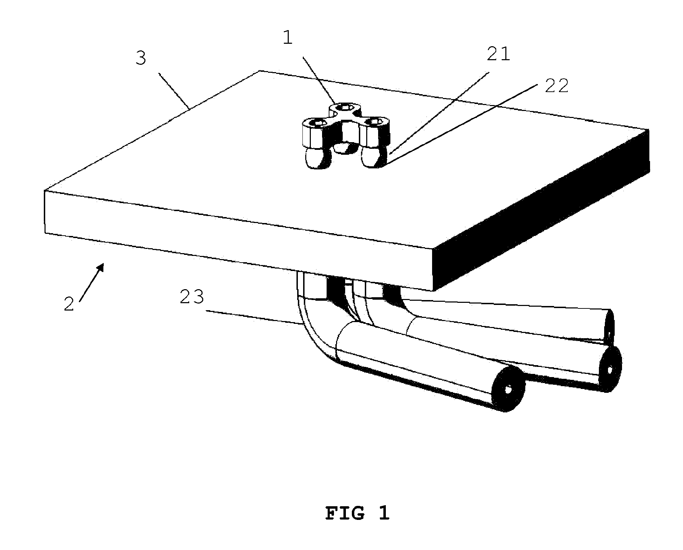

Referring to figure 1, apparatuses according to the invention comprise a table 1, for which compliance is desired, and support means 2 for supporting the table 1. It is the support means 2 which allows for the compliance of the table 1 to be achieved. The table 1 hence can be regarded as having a much larger stiffness (at least one order of magnitude, preferably two orders of magnitude) than its support 2.

The support means 2 are arranged to form menisci 21 (or bubbles) at the interface between two fluids. The table 1 is arranged to be supported by the menisci 21, such that the table rests on them and makes contact with the interfaces (menisci 21). The load of the table 1 can be born by the menisci 21 when an equilibrium can be found between the pressure in the fluid at the side of the meniscus opposite to the table, the surface tension and the resulting load of the table.

Basically, if the table is supported at two points (or locations) by menisci, compliance in respect of two rotational degrees of freedom can be achieved. In order to be isostatically determined, the table can be supported at a third location by a third meniscus, or any other means, such as by a spherical joint, a spring, etc.

Figure 1 depicts the case wherein the table 1 is supported by three menisci 21 at three points. This will allow for compliance in respect of two rotational degrees of freedom (rotation on axes going through support points) and of one translational degree of freedom (translation perpendicular to the plane defined by the three support points. Since the menisci can provide for some lateral elasticity, a (more limited) compliance in respect of the other degrees of freedom can be obtained as well.

The menisci 21 are each formed at separate locations. These locations are preferably situated underneath the table and more preferably at a distance therefrom. A single meniscus 21 (bubble) is preferably formed at each location.

In the case of figure 1, the table 1 is supported by the menisci 21 only. No additional supports are provided.

In case of significant lateral forces would be present, the table 1 can be supported laterally as well, such as by providing menisci 21 sideways (laterally) to the table 1. Alternatively, abutments for limiting the lateral motion of the table can be provided.

The invention provides for anchoring the menisci 21, preferably at the location where they are formed. Therefore, anchoring edges 22 are provided at each anchoring location. The anchoring edges are preferably geometrical edges, such as those edges surrounding an aperture, the end of a tube, etc. They are preferably of circular shape. The anchoring edges 22 can be chemically defined, e.g. they can refer to the border of a surface patch which has different wettability properties with respect to either one or both fluids than the adjacent surface.

The anchoring edge 22 forms an edge or boundary of the meniscus 21. The meniscus 21 hence preferably develops from the anchoring edge 22.

The provision of an anchoring edge 22 has multiple advantages. Firstly, it allows the generation of a meniscus at a precise, predetermined location. Secondly, it provides increased stability, and reduces the risk of a meniscus migrating, which can lead to instabilities in the positioning of the table. Thirdly, it increases the robustness of the system. If, for whatever reason, such as an excessive load exerted on the table, the meniscus would escape (e.g. by forming a bubble detaching from the anchoring edge), a new meniscus can easily be formed at the same location. The support of the table hence can easily be restored in case of failure.

In order to form a meniscus 21, two fluid phases are required. A first fluid phase surrounds the table 1. The table can be completely immersed in the first fluid (phase). Alternatively, it can be partially immersed therein, such that at least the portions of the table which will be in contact with the menisci 21 are submerged in the first fluid (phase). A second fluid phase is supplied in proximity of the table and preferably in proximity of the anchoring edges 22. The second fluid is arranged to form an interface with the first fluid at each separate location, giving rise to the meniscus 21.

As shown in figure 1, the anchoring edges 22 for the menisci 21 are preferably formed by the internal edge of the end of a tube 23. The tube 23 supplies the second fluid to the location where the menisci are generated. For each such location, a tube 23 is provided. Each meniscus location preferably has its separate supply of second fluid, such as a separate tube 23. The tube 23 is in fluid connection with meniscus generating means, such as a pump, for example a piston pump (a syringe).

It is also possible to generate the second fluid within the first fluid, such as e.g. electrolytically, or thermally. The tubes 23 then could be replaced by a recess for the generation of the second fluid, comprising electrodes or heating means.

Micro-assembly in a liquid environment has advantageous effects, since the influence of parasitic forces can be reduced. For example, electrostatic forces are reduced if the permittivity of the liquid medium is larger than the permittivity of air. Surface tension effects disappear if there is no air-liquid interface. Therefore, advantageously, the first fluid (phase) can be liquid. In such case, the second fluid (phase) is preferably a gas phase, such as air. Alternatively, the first fluid can be a gas phase, such as air and the second fluid can be a liquid phase.

In case the first fluid is a liquid, the table 23 can be only partially submerged therein, such that, for example, the table (upper) surface extends outside and above the liquid level. However, complete submersion of the table enables micro-assembly in a liquid environment, which can be advantageous as indicated above.

In case the first fluid is a liquid, a receptacle is preferably provided for containing the liquid. The tubes 23 then preferably abut on the bottom 3 of such receptacle, as represented in figure 1.

Control of the meniscus' shape depends on the type of fluid used as the second fluid (i.e. the fluid at the concave side of the meniscus). If the second fluid is a liquid, then it can be assumed that the volume of the liquid remains constant. Hence, displacement of a piston in fluid connection with the tube 23 leads to a same volume increase at the interface of the meniscus.

In case the second fluid is a gas phase, such as air, a constant mole approach can be used. In the assumption that during use, the tubing supplying the second fluid to the anchoring edge 22 (and the interface 21) is a closed duct, the number of gas molecules in the tubing may reasonably be assumed to remain constant. Gravitational forces may be neglected and a uniform pressure P in the second fluid throughout the tubing can be assumed. The meniscus is then governed by the following relations: the Laplace equation, the ideal gas law and the equations describing the geometry of the meniscus. When a spherical meniscus is assumed (forming a spherical cap), defined by a height h and radius r, a circular anchoring edge, defined by diameter s and the amount of gas molecules in the tubing is equal to n moles, then the above relations can be written as follows:

$$\frac{2\gamma}{r} = P - P_0$$

$$P(V_M + V_0 - V_P) = nRT$$

$$r = \frac{s^2}{8h} + \frac{h}{2}$$

$$V_M = \frac{\pi h}{6}\left(\frac{3s^2}{4} + h^2\right)$$

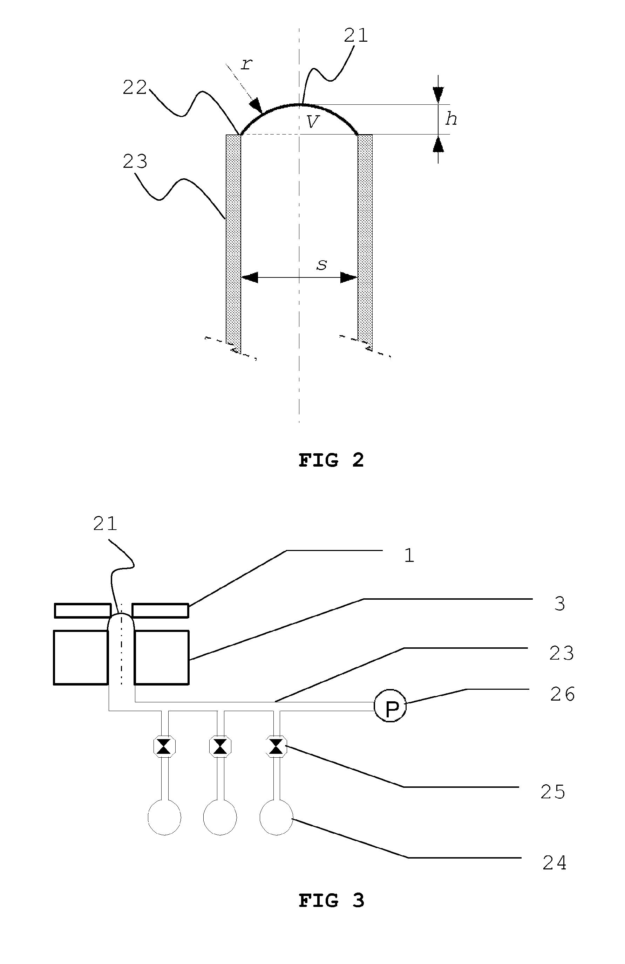

The first equation represents the Laplace equation, linking the pressure gradient $P-P_0$ across the interface, between the first fluid ($P_0$) and the second fluid (P), with the mean curvature $2/r$ of the interface, and the surface tension y. The second equation represents the ideal gas law and takes the compressibility of the gas into account. R represents the universal gas constant and T the temperature. $V_0$ represents the initial volume of the system; $V_M$ represents the volume increase created by the meniscus and is defined by the last equation; $V_P$ represents the volume displaced by a pump (to pressurize the second fluid so as to generate the meniscus). The third equation expresses a relation between the curvature and the height of the meniscus, and the diameter of the anchoring edge (see figure 2).

A governing equation for the meniscus can be distilled from the former set, in function of one parameter determining the shape of the meniscus (e.g. $r$, $h$, $V_M$). Resolving, for example, for h, gives the following governing equation:

$$\frac{\pi}{12}P_0 h^5 + \frac{\pi}{3}\gamma h^4 + \frac{\pi}{12}P_0 s^2 h^3 + \left[-\frac{1}{2}nRT + \frac{1}{2}P_0\left(V_0 - V_P\right) + \frac{\pi}{4}\gamma s^2\right]h^2$$

$$+\left[\frac{\pi}{64}P_0 s^4 + 2\gamma\left(V_0 - V_P\right)\right]h + \frac{1}{8}P_0 s^2\left(V_0 - V_P\right) - \frac{1}{8}nRTs^2 = 0$$

which is a fifth order polynomial with $h$ as dependent variable. The equation can easily be solved by numerical methods and can have one, three or five real roots. The range of solutions having one real root refers to the stable range. Combinations leading to more than one real root relate to unstable ranges, e.g. where the meniscus can suddenly grow from a shape smaller than a hemisphere to a larger one. The latter operating conditions should be avoided.

Where the governing equation has one real root, a 1:1 relationship exists between the shape (and size) of the meniscus and the volumetric displacement effected e.g. by a reciprocating pump.

The meniscus is preferably arranged to be of spherical shape (spherical cap or segment) and more preferably to have a size smaller than or equal to a hemisphere.

The size of the meniscus is preferably so selected that, in a static (equilibrium) condition, the distance between the anchoring edge 22 and the table 1 does not exceed the capillary length of the combination of first and second fluid. The capillary length L is defined as:

$$L = \sqrt{\frac{\gamma}{\rho g}} \ ,$$

where ρ is the density of the denser fluid of the two and g is the gravitational constant. Such a choice results in that gravitational forces remain negligible in the dynamics of the meniscus.

The use of a gas phase as the second fluid allows to easily obtain a desired stiffness of the table support, or as it may be referred to, the table suspension. In fact, the second fluid fills a volume that can be much larger than the volume of just a spherical bubble having equal radius as the meniscus 21. Combined with the natural compressibility of gases, or air, this can give quite high compliance levels to the table, especially as regards stiffness in a direction perpendicular to the meniscus.

Particularly in case a gas is used as second fluid, the stiffness of a point of meniscus support of the table, can be kept smaller than or equal to 20 N/m. It can be adjustable in the range between 0.1 N/m and 20 N/m, with values between 10 N/m and 0.1 N/m being preferred. Such values can however be obtainable with a liquid as second fluid as well.

Furthermore, the volume occupied by the second fluid, which is in fluid communication with the meniscus can be adjustable in order to allow adjustment of the stiffness of the table support. This is schematically illustrated in figure 3. A plurality of tanks 24 can be closably connected to the tube 23 which is in fluid communication with the meniscus. Prior to using the apparatus for a given operation (e.g. an assembly task), the desired stiffness of the table support is determined. Based thereon, the volume of second fluid in fluid communication with the meniscus, required to obtain the predetermined stiffness can be calculated. The valves 25 of one or more tanks 24 can be opened in order to adjust the volume to the calculated one.

It is to be noticed that the valves 25 are preferably only operated before the beginning of an operation and possibly at the end thereof. They are preferably not actuated dynamically, during an operation on the table, since this may cause discontinuities in the compliance level (stiffness of the menisci 21).

A pump for pressurizing the second fluid and generating the meniscus can be provided in addition to the tanks 24. The tubing 23 can alternatively be closably connected to an (external) supply of second fluid, e.g. a (pressurized) gas supply tank through a pressure control valve. When the apparatus is in use, however, the supply is preferably disconnected from the tube 23.

A pressure sensor 26 can be connected to the tube 23. According to the governing equation in case of gases as second fluid, a unique relationship exist between the pressure in the second fluid and the size of the (stable) meniscus. The pressure sensor 26 can therefore be used to control the meniscus' size.

Apparatuses of the invention can comprise means for measuring the size of the meniscus, such as by a laser beam. The latter systems can be arranged at a distance from the meniscus and are moreover non-contact measurement devices, so that they advantageously do not interfere with the functioning of the apparatus.

When the second fluid is a liquid and since the latter can be assumed to be incompressible, the tanks 24 indicated above are of little use. For such case, they can be replaced by one or more expansion tanks comprising a flexible membrane. These allow for some flexibility in the tubing 23 and hence impart a compliance to the table support. A pressure sensor can be provided in the air (gas) chamber of the expansion tank.

The arrangements described above can be used for measuring the force applied on the table, which relates to another aspect of the invention. In fact, when a gas phase is used as second fluid, it can be derived from the governing equation of the meniscus that in a system of finite stiffness, the meniscus' size will alter when the external pressure $P_0$ changes. When moreover all other parameters remain constant, the meniscus' size can be a direct indication of the external pressure and hence of the force that is applied on the meniscus, such as by the table. Hence, during operation, and assuming a closed volume of second fluid, the pressure measured by pressure sensor 26 can be directly related to the force exerted by the table on the meniscus. Having an independent meniscus generating system for each meniscus, the force exerted on the table can be measured for each meniscus independently.

More precisely, each pressure sensor 26 can be used to measure one degree-of-freedom remotely. In this case, for each degree-of-freedom, the couple (force-position) can be computed on the knowledge of the couple (volume-pressure).

When a liquid is used as second fluid, the force exerted by the table on the meniscus can be measured as well, for example when using an expansion tank with a flexible membrane and a closed air chamber and pressure sensor connected thereto.

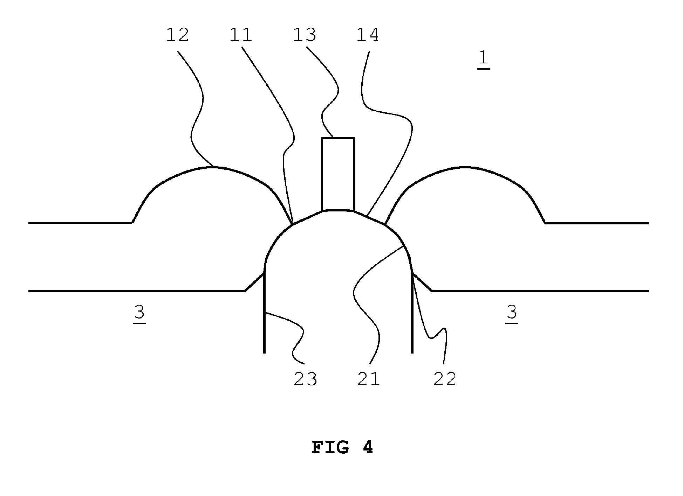

As far as the table 1 is concerned, it preferably comprises means for anchoring the meniscus thereto, which can be geometrical means, such as anchoring points, or anchoring edges, so arranged that the meniscus is biased to contact the table at the anchoring points or edges by capillarity. This is known in the art as a "capillary stop". An example is represented in figure 4. The capillary stop in figure 4 comprises a (sharp) anchoring edge 11 surrounded by a recess 12 which bounds on the edge 11 with an inclined wall. As a result, the meniscus 21 is pinned at the edge.

At the location where it is supported by the meniscus 21, the table 1 may be provided with a recess 13, preferably a blind hole, which can ease manufacturing of the support face 14.

The anchoring effect can be provided chemically as well, such as by providing a surface patch (e.g. ring-shaped) on the table's surface that has poor wettability properties for the second fluid. An example for water, is a $CHF_3$ coating which makes the surface hydrophobic with a contact angle for water of about 102°. An other example, is the modification of silicon dioxide and glass surfaces with octadeciyltrichlorosilane to make the surface hydrophobic with a contact angle of about 102° and 103° respectively. This can be performed by hydroxylation. Alkylsiloxane molecules are absorbed on the surface and Si-O covalent bonds can be formed by dehydration of $H_2O$ molecules.

The anchoring means furthermore preferably enable to center or align the table relative to the meniscus.

**Claims**

1. Apparatus for providing a compliance to an element (1), comprising the element (1) and means (2) for supporting the element so as to allow, in use, for at least two rotational degrees of freedom of the element, **characterised in that** the means (2) for supporting the element comprises:

   - an anchoring edge (22) for a meniscus (21), provided at each of at least two separate locations isolated from the element (1) and in contact with a first fluid in which the element (1) is at least partially immersed when in use,
   - means for generating a meniscus (21) at each of the separate locations, from an interface between the first fluid and a second fluid, so that the meniscus (21) is anchored to the corresponding anchoring edge (22) when in use,

   wherein the element (1) is arranged to be supported by each of the menisci (21) so that the compliance to the element can be provided and wherein the separate locations are arranged so that the compliance can be provided in respect of said rotational degrees of freedom.

2. Apparatus of claim 1, arranged to generate a meniscus (21) in at least three separate locations for supporting the element (1).

3. Apparatus of claim 2, wherein the element (1) is exclusively supported by the menisci (21), the element thereby being compliant in respect of at least two rotational degrees of freedom and at least one translational degree of freedom.

4. Apparatus of any one preceding claim, comprising a tubular cavity (23) arranged to contain the second fluid and abutting on the anchoring edge (22) corresponding to one of the menisci (21), wherein, in use, the second fluid in the tubular cavity (23) is in fluid connection with the meniscus (21).

5.  Apparatus of claim 4, wherein the tubular cavity (23) is arranged to have a variable volume for containing the second fluid in fluid connection with the meniscus, enabling adjustment of the stiffness of the meniscus.

6.  Apparatus of claim 5, wherein the volume is kept constant and in isolation when in use, thereby imparting a predetermined stiffness to the meniscus (21) during use.

7.  Apparatus of claim 5 or 6, comprising a plurality of reservoirs (24) arranged to contain the second fluid and being individually connectable to a same tubular cavity (23), so as to be in fluid communication with the tubular cavity for adjusting the stiffness of the meniscus (21).

8.  Apparatus of any one preceding claim, comprising means (26) for measuring pressure variations in the second fluid in fluid connection with the meniscus (21).

9.  Apparatus of any one preceding claim, wherein the first fluid is a liquid and the second fluid is a gas phase.

10. Apparatus of any one preceding claim, wherein the element (1) comprises geometrical anchoring points (11) for anchoring the meniscus (21) to the element by capillarity.

11. Apparatus of any one preceding claim, wherein the element comprises chemical anchoring points for anchoring the meniscus to the element by differences in wettability of the element's surface.

12. Apparatus of any one preceding claim, wherein the meniscus (21) is arranged to provide a stiffness to the element (1) smaller than or equal to 20 N/m.

13. Method of measuring a force applied on an element (1), the method comprising the steps of:

    - generating at least one meniscus (21) forming an interface between a first fluid in which the element (1) is at least partially immersed and a second fluid, so that the element (1) is in contact with the meniscus (21),
    - arranging the second fluid in isolation, so that any pressure variation in the second fluid is induced by a change of the meniscus (21), and
    - measuring the pressure variation in the second fluid.

14. Method of claim 13, wherein the first fluid is a liquid and the second fluid is a gas or air.

15. Method of claim 13 or 14, wherein the meniscus is formed at the end of a tubular cavity (23) containing the second fluid and wherein the pressure variation is measured in the tubular cavity, remote from the meniscus (21).

FIG 1

**FIG 2**

**FIG 3**

FIG 4

Europäisches
Patentamt

European
Patent Office

Office européen
des brevets

## EUROPEAN SEARCH REPORT

Application Number

EP 09 17 2715

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A,D | C. CLÉVY ET AL.: "FLEXIBLE MICRO-ASSEMBLY SYSTEM EQUIPPED WITH AN AUTOMATIC TOOL CHANGER" JOURNAL OF MICRO-NANO MECHATRONICS, vol. 4, 22 July 2008 (2008-07-22), XP002575383 * paragraph [05.2]; figure 15 * | 1 | INV.<br>B81B3/00<br>G01L1/02 |
| A,D | WO 01/94823 A1 (UNIV CALIFORNIA [US]) 13 December 2001 (2001-12-13) * claim 1; figure 1 * | 1 | |
| A | JP 59 083035 A (FUJI DENKI SOGO KENKYUSHO KK) 14 May 1984 (1984-05-14) * abstract * | 1 | |
| A | US 5 012 570 A (HOSKINS ROBERT G [US] ET AL) 7 May 1991 (1991-05-07) * column 2, line 54 - line 68; figure 1 * | 1 | |
| A | WO 2004/017048 A1 (GBC SCIENT EQUIP PTY LTD [AU]; GREY RONALD GARWOOD [AU]; CONDICK GEOFF) 26 February 2004 (2004-02-26) * claim 27; figure 4 * | 1 | TECHNICAL FIELDS SEARCHED (IPC)<br><br>B81B<br>B01L<br>G01L |
| A | US 2006/132898 A1 (TURNER ARTHUR M [US] ET AL TURNER ARTHUR MONROE [US] ET AL) 22 June 2006 (2006-06-22) * paragraphs [0006], [0 18]; figures 2A, 2B * | 1 | |
| A | WO 2005/071447 A1 (KONINKL PHILIPS ELECTRONICS NV [NL]; HENDRIKS BERNARDUS H W [NL]; KUIP) 4 August 2005 (2005-08-04) * claim 1; figure 1 * | 13 | |

-/--

The present search report has been drawn up for all claims

| Place of search | Date of completion of the search | Examiner |
|---|---|---|
| The Hague | 21 May 2010 | Krikorian, Olivier |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

**Europäisches Patentamt**
**European Patent Office**
**Office européen des brevets**

# EUROPEAN SEARCH REPORT

Application Number

EP 09 17 2715

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | JP 2005 147943 A (SEIKO EPSON CORP) 9 June 2005 (2005-06-09) * abstract * ----- | 13 | |

TECHNICAL FIELDS SEARCHED (IPC)

The present search report has been drawn up for all claims

| Place of search | Date of completion of the search | Examiner |
|---|---|---|
| The Hague | 21 May 2010 | Krikorian, Olivier |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

........................................................................

& : member of the same patent family, corresponding document

EPO FORM 1503 03.82 (P04C01)

Europäisches
Patentamt

European
Patent Office

Office européen
des brevets

Application Number

EP 09 17 2715

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

see sheet B

☒ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☐ None of the further search fees have been paid within the fixed time limit. The present European search report has been drawn up for those parts of the European patent application which relate to the invention first mentioned in the claims, namely claims:

☐ The present supplementary European search report has been drawn up for those parts of the European patent application which relate to the invention first mentioned in the claims (Rule 164 (1) EPC).

Europäisches
Patentamt
European
Patent Office
Office européen
des brevets

**LACK OF UNITY OF INVENTION
SHEET B**

Application Number

EP 09 17 2715

The Search Division considers that the present European patent application does not comply with the requirements of unity of invention and relates to several inventions or groups of inventions, namely:

```
1. claims: 1-12

        Apparatus for providing a compliance to an element
                          ---

2. claims: 13-15

        Method for measuring a force applied to an element
                          ---
```

**ANNEX TO THE EUROPEAN SEARCH REPORT**
**ON EUROPEAN PATENT APPLICATION NO.**

EP 09 17 2715

This annex lists the patent family members relating to the patent documents cited in the above-mentioned European search report.
The members are as contained in the European Patent Office EDP file on
The European Patent Office is in no way liable for these particulars which are merely given for the purpose of information.

21-05-2010

| Patent document cited in search report | | Publication date | Patent family member(s) | | Publication date |
|---|---|---|---|---|---|
| WO 0194823 | A1 | 13-12-2001 | AU | 6516001 A | 17-12-2001 |
| JP 59083035 | A | 14-05-1984 | JP | 1006913 B | 06-02-1989 |
| | | | JP | 1522758 C | 12-10-1989 |
| US 5012570 | A | 07-05-1991 | NONE | | |
| WO 2004017048 | A1 | 26-02-2004 | AU | 2003250579 A1 | 03-03-2004 |
| | | | AU | 2008255184 A1 | 08-01-2009 |
| | | | DE | 10393039 T5 | 08-09-2005 |
| | | | GB | 2407642 A | 04-05-2005 |
| | | | JP | 2005535890 T | 24-11-2005 |
| | | | JP | 2009236924 A | 15-10-2009 |
| | | | US | 2005247115 A1 | 10-11-2005 |
| | | | US | 2007151330 A1 | 05-07-2007 |
| US 2006132898 | A1 | 22-06-2006 | NONE | | |
| WO 2005071447 | A1 | 04-08-2005 | CN | 1910427 A | 07-02-2007 |
| | | | US | 2009013544 A1 | 15-01-2009 |
| JP 2005147943 | A | 09-06-2005 | NONE | | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• WO 0194823 A

**Non-patent literature cited in the description**

• **C. CLÉVY et al.** Flexible micro-assembly system equipped with an automated tool changer. *Journal of Micro - Nano Mechatronics,* 2008, vol. 4, 59-72